# EUROPÄISCHE PATENTSCHRIFT

(11) **EP 1 514 302 B1**
(45) Veröffentlichungstag und Bekanntmachung des Hinweises auf die Patenterteilung: **07.01.2009**
(21) Anmeldenummer: 03740090.0
(22) Anmeldetag: 16.06.2003
(51) Int. Cl.: H01L 21/48

(54) **VORRICHTUNG FÜR DIE HERSTELLUNG EINES ELEKTRONISCHEN BAUTEILS MIT AUSSENKONTAKTFLÄCHEN UND VERWENDUNG DER vORRICHTUNG ZUR HERSTELLUNG EINES ELEKTRONISCHEN BAUTEILS**
DEVICE FOR PRODUCING AN ELECTRONIC COMPONENT HAVING EXTERNAL CONTACT SURFACES AND USE OF THE DEVICE FOR PRODUCING AN ELECTRONIC COMPONENT
DISPOSITIF DE FABRICATION D'UN COMPOSANT ELECTRONIQUE PRESENTANT DES SURFACES DE CONTACT EXTERIEURES ET UTILISATION DU DISPOSITIF POUR LA FABRICATION D'UN COMPOSANT ELECTRONIQUE

(30) Priorität: 17.06.2002 DE 10227045
(43) Veröffentlichungstag der Anmeldung: 16.03.2005
(73) Patentinhaber: Infineon Technologies AG, 81669 München (DE)
(72) Erfinder: GRÖNINGER, Horst, 93142 Maxhütte-Haidhof (DE)
(74) Vertreter: Schäfer, Horst
(86) Internationale Anmeldenummer: PCT/DE2003/002014
(87) Internationale Veröffentlichungsnummer: WO 2003/107413

(56) Entgegenhaltungen:
- EP-A- 0 726 698
- EP-A- 0 757 386
- WO-A-02/28586
- US-A- 5 227 604
- US-A- 5 514 414
- US-A1- 2001 008 310
- US-B1- 6 271 111

## Beschreibung

Aufgrund der immer größer werdenden Außenflächen von in Kunststoff verpackten elektronischen Bauteilen setzen sich immer stärker Außenkontaktflächen, die auf der Unterseite des elektronischen Bauteils angeordnet sind und der Verbindung des elektronischen Bauteils mit übergeordneten Schaltungsanordnungen dienen. Derartige Außenkontaktflächen lösen die bisher am Rand angeordneten Kontaktbeinchen in Form von Außenflachleitern ab.

Zur Vorbereitung des Verbindens der Außenkontaktflächen mit einer übergeordneten Schaltungsanordnung oder mit zusätzlich anzubringenden Lothöckern oder Lotbällen werden diese flächigen Außenkontaktflächen mit einer lötbaren Schicht überzogen. Diese Schicht aus Metallen oder Metall-Legierungen wird auf den Außenkontaktflächen galvanisch abgeschieden und bildet dabei eine matte Oberfläche mit scharfkantigen Rändern. In diesem Zusammenhang wird unter galvanischem Abscheiden sowohl eine stromlose Abscheidung aus einem chemischen Bad als auch eine elektrolytische strombehaftete Abscheidung in einem Elektrolytbad verstanden.

Eine derartige galvanisch abgeschiedene Schicht wirkt sich jedoch bei Funktionstests des elektronischen Bauteils ungünstig auf den Übergangs- und den Kontaktwiderstand und insbesondere auf die Lebensdauer der elastischen Testkontakte aus, zumal diese schon nach wenigen Testzyklen mit dem Schichtmaterial der Außenkontaktflächen kontaminiert sind.

Aufgabe der Erfindung ist es, die Eigenschaften galvanisch abgeschiedener Schichten auf Außenkontaktflächen zu verbessern und eine **Vorrichtung zur Herstellung eines** elektronischen Bauteils zu schaffen, das eine zuverlässige Testung bei niedrigen Kontaktübergangswiderständen und stabilen Übergangswiderständen der beschichteten Außenkontaktflächen ermöglicht.

Gelöst wird diese Aufgabe mit dem Gegenstand der unabhängigen Ansprüche. Vorteilhafte Weiterbildungen der Erfindung ergeben sich aus den abhängigen Ansprüchen.

**In einem mit der erfindungsgemäßen Vorrichtung durchführbaren** Verfahren für die Herstellung eines elektronischen Bauteils mit Außenkontaktflächen **weisen** die Außenkontaktflächen eine Schicht aus Metall oder aus einer Metall-Legierung auf und die Dicke der Schicht eines Außenkontaktes **nimmt** von einem Zentrumsbereich zu einem Randbereich ab. Dazu werden die nachfolgenden Verfahrensschritte durchgeführt. Zunächst wird ein elektronisches Bauteil mit Außenkontaktflächen, die eine galvanisch abgeschiedene, matte, unebene und scharfkantige Schicht aus Metall oder Metall-Legierungen auf den Außenkontaktflächen aufweisen, hergestellt. Anschließend wird diese galvanisch abgeschiedene Schicht fließtechnisch bearbeitet, indem das elektronische Bauteil in einer reduzierenden Atmosphäre, insbesondere in einer ameisensäuredampfhaltigen Schutzgasatmosphäre, bis mindestens zu der Fließtemperatur der Schichtoberfläche erwärmt wird.

Dieses Verfahren hat den Vorteil, dass das Herstellungsverfahren von elektronischen Bauteilen einschließlich der galvanischen Abscheidung von Schichten mit matten Oberflächen beibehalten werden können. Auch die bisher galvanisch abgeschiedenen Metalle und Metall-Legierungen können unverändert eingesetzt werden. Darüber hinaus hat das Verfahren den Vorteil, dass keine mechanische oder chemomechanische Nachbearbeitung der Außenkontaktflächen erforderlich ist, um die galvanisch abgeschiedene, matte und unebene sowie scharfkantige Schicht auf den Außenkontaktflächen derart zu verbessern, dass die matte und damit raue Oberfläche in eine glänzende und damit glatte Oberfläche überführt wird. Darüber hinaus liefert das Verfahren eine verbesserte Schicht, indem die Dicke der Schicht eines Außenkontaktes von einem Zentrumsbereich zu einem Randbereich abnimmt und somit die Scharfkantigkeit der Beschichtung der Außenkontakte überwunden wird.

Ferner konnte festgestellt werden, dass eine reduzierende Atmosphäre, insbesondere eine ameisensäuredampfhaltige Schutzgasatmosphäre, beim Erreichen der Fließtemperatur der Schichtoberfläche nicht nur die Schichtoberfläche glättet und in dem Randbereich der Schicht abrundet, sondern die Metalle oder Metall-Legierungen der Schicht von Metalloxiden befreit, so dass ein verbesserter elektrischer Kontaktwiderstand und ein stabiler Übergangswiderstand beispielsweise zu Testkontakten eines Testkopfes erreicht werden kann. Schließlich konnte festgestellt werden, dass gleichzeitig die Schichtoberfläche nach der erfindungsgemäßen fließtechnischen Bearbeitung gehärtet wird, so dass ein elektronisches Bauteil mit gehärteten, geglätteten, in den Randbereichen abgerundeten und oxidfreien Außenkontaktflächen zur Verfügung steht.

Um eine ameisensäuredampfhaltige Schutzgasatmosphäre zu erzeugen, kann ein Schutzgas durch einen Ameisensäuredampf geleitet werden, wobei HCOOH-Moleküle der Ameisensäure mit dem Schutzgas mitgerissen werden. Bei einem derartigen Durchführungsbeispiel des Verfahrens kann die Ameisensäurekonzentration in dem Schutzgas über die Durchflussmenge an Schutzgas pro Zeiteinheit durch den Ameisensäuredampfbereich reguliert werden. Darüber hinaus kann die Ameisensäurekonzentration in der ameisensäuredampfhaltigen Schutzgasatmosphäre durch das Erwärmen von Ameisensäure bei Temperaturen zwischen 40°C und 60°C eingestellt werden.

Die Konzentration der HCOOH-Moleküle kann darüber hinaus durch einen entsprechenden Druck über dem Spiegel der Ameisensäure zwischen 0,5 und 1 MPa gesteuert werden. Der Druck in einem Ameisensäuredampferzeuger kann durch die Schutzgaszufuhr eingestellt werden. Als Schutzgas kann ein Inertgas dienen, das keinerlei Reaktionen mit dem Ameisensäuredampf und den Materialien des elektronischen Bauteil, insbesondere mit der fließtechnisch zu bearbeitenden Schicht auf den Außenkontakten eingeht.

Als Schutzgas kann auch Formiergas eingesetzt werden, das mit seinem Wasserstoffanteil die Reduktion von Metalloxiden an der Schichtoberfläche unterstützt. Eine weitere Möglichkeit besteht darin, als Schutzgas Stickstoff einzusetzen. Das hat den Vorteil, dass Stickstoff gegenüber anderen Inertgasen relativ preiswert und damit kostengünstig zu beschaffen ist.

In einem bevorzugten Ausführungsbeispiel des Verfahrens ist es vorgesehen, dass das elektronische Bauteil innerhalb von 20 bis 40 Sekunden auf eine erste Haltetemperatur erwärmt wird und anschließend in 10 bis 30 Sekunden auf eine zweite, höhere Haltetemperatur gebracht wird und schließlich in 15 bis 30 Sekunden auf eine höchste Endtemperatur, die mindestens der Fließtemperatur der Schichtoberfläche entspricht, erhitzt wird. Nach Erreichen der Fließtemperatur als höchste Endtemperatur des Verfahrens kann das elektronische Bauteil mit einer Abkühlrate von 5°C pro Sekunde bis 10°C pro Sekunde auf Raumtemperatur abgekühlt werden, ohne dass Mikrorisse oder andere Defekte am elektronischen Bauteil feststellbar sind.

Die oben erwähnten Haltetemperaturen und Endtemperaturen sind von dem Material der galvanisch abgeschiedenen Schicht auf den Außenkontaktflächen abhängig. Bei einer bevorzugten ' Durchführung des Verfahrens werden die Außenkontaktflächen mit einer lötbaren Schicht galvanisch beschichtet. Dazu kann eine Zinn/Blei-Legierung auf die Außenkontaktflächen aufgebracht werden, die sich aus 80 Atom % Zinn und 20 Atom % Blei zusammensetzt.

Die Schicht kann auch aus einer Zinn/Blei/Silber-Legierung bestehen. In dieser Zinn/Blei/Silber-Legierung ist Zinn mit 50 bis 70 Atom %, Blei mit 30 bis 40 Atom % und Silber mit 1 bis 10 Atom % enthalten. Bei einer derartig zusammengesetzten Beschichtung wird zunächst das elektronische Bauteil auf eine erste Haltetemperatur von 100 bis 110°C, anschließend auf eine zweite Haltetemperatur von 150 bis 170°C und schließlich auf die Endtemperatur von 200 bis 220°C erhitzt. Dabei liegen die erste und die zweite Haltetemperatur unterhalb der Fließtemperatur der Oberfläche der jeweiligen Beschichtungslegierung.

Die erste Haltetemperatur liegt über dem Verdampfungspunkt von Wasser, wodurch die Oberfläche der galvanisch abgeschiedenen Schicht getrocknet wird. Die zweite Haltetemperatur liegt wenige 10° unterhalb der Fließtemperatur der Oberfläche, so dass eine kurze Aufheizphase ausreicht, um ein oberflächennahes Fließen und damit ein Glätten der galvanisch abgeschiedenen matten Schicht zu erreichen. Um zu gewährleisten, dass sämtliche Außenkontakte eines elektronischen Bauteils die zweite Haltetemperatur sicher erreichen, wird die zweite Haltetemperatur für 20 bis 40 Sekunden beibehalten, bevor das elektronische Bauteil auf die Endtemperatur erhitzt wird. Dabei kann die Endtemperatur geringfügig über der Fließgrenze für das galvanisch abgeschiedene Material liegen.

Nach dem fließtechnischen Bearbeiten der Außenkontaktflächen kann das elektronische Bauteil durch Anpressen von elastischen Messkontakten auf die beschichteten Außenkontaktflächen getestet werden. Aufgrund der Glättung und Härtung der Oberfläche der Schicht auf den Außenkontaktflächen wird die Migration von Metall-Legierungsbestandteilen wie Zinn oder Blei auf die elastischen Kontakte des Testkopfes vermindert, so dass die Lebensdauer der Testköpfe verbessert wird. Darüber hinaus wird durch die oxidfreie Oberfläche ein wesentlich geringerer und gleichmäßigerer Übergangswiderstand für den Testvorgang bereitgestellt. Somit sind die Nachteile von matten, unebenen und scharfkantigen galvanisch abgeschiedenen Beschichtungen auf den Außenkontaktflächen überwunden. Insbesondere kann ein häufiges Reinigen oder ein vorzeitiges Ersetzen der elastischen Kontakte beziehungsweise des Testkopfes vermieden werden.

Das Verfahren bietet auch Vorteile, wenn Kontaktbälle oder Kontakthöcker auf den Außenkontaktflächen des elektronischen Bauteils aufgebracht werden sollen. In diesem Fall werden die Kontaktbälle oder Kontakthöcker auf den Außenkontakten der Bauteile vorjustiert und mit Flussmittel vorpositioniert und anschließend in einer ameisensäuredampfhaltig Schutzgasatmosphäre auf die beschichteten Außenkontaktflächen aufgeschmolzen. Durch die HCOOH-Moleküle des Ameisensäuredampfes werden die miteinander zu verschmelzenden Oberflächen reduziert, wobei entstehende Formiate bei den Bearbeitungstemperaturen flüchtig sind. Neben der Verschmelzung oxidfreier Oberflächen wird durch die ameisensäuredampfhaltige Schutzgasatmosphäre zusätzlich erreicht, dass die Oberflächen der entstehenden Außenkontakthöcker und Außenkontaktbälle oberflächengehärtet und oxidfrei werden.

Eine **erfindungsgemäße** Vorrichtung für die Herstellung eines elektronischen Bauteils mit Außenkontaktflächen, die eine Schicht aus Metall oder aus einer Metall-Legierung aufweisen, wobei die Dicke der Schicht eines jeden Außenkontaktes von dem Zentrumsbereich zu einem Randbereich der Außenkontaktflächen abnimmt, weist nachfolgende Einrichtungen auf: Einen Mehrzonenofen mit Eingangs- und Ausgangspforte und mit einer Druckgaszuführung sowie einen Ameisensäuredampferzeuger mit Heizung und einer Schutzgaszuführung, wobei die Schutzgaszuführung mit dem Ameisensäuredampferzeuger verbunden ist. Diese Vorrichtung hat den Vorteil, dass es der Mehrzonenofen ermöglicht, in unterschiedlichen Heizzonen die erste Haltetemperatur, die zweite Haltetemperatur und die Endtemperatur im Bereich der Fließtemperatur der Oberfläche der zu glättenden Schicht getrennt einzustellen und zu regeln. Darüber hinaus hat ein Mehrzonenofen den Vorteil, dass das Verfahren im Durchlauf durchgeführt werden kann mit beispielsweise einer Taktfolge von 20 bis 30 Sekunden Verweilzeit in jeder der Zonen des Ofens.

Der Ameisensäuredampferzeuger hat im Zusammenwirken der Schutzgaszuführung den Vorteil, dass das Mischen zwischen Ameisensäuredampf und Schutzgas außerhalb des Mehrzweckofens durchgeführt werden kann und ein Zuführungsdruck des ameisensäuredampfhaltigen Schutzgases getrennt vom Volumen und der Größe des Mehrzonenofens eingestellt werden kann. Über die Druckgaszuführung zwischen Mehrzonenofen und Ameisensäuredampferzeuger wird gewährleistet, dass eine ausreichende Menge an ameisensäuredampfhaltigem Schutzgas in den Mehrzonenofen gelangt und die Eingangs- und Ausgangspforte des Mehrzonenofens spült wird, so dass ein Eindringen von Luftsauerstoff über die Eingangs- und Ausgangspforte unterbunden wird.

Der Ameisensäuredampferzeuger der erfindungsgemäßen Vorrichtung kann einen Druckbehälter aufweisen, der in seinem unteren Bereich mit Ameisensäure gefüllt ist und in diesem Bereich von einer Heizung umgeben ist, wobei die Schutzgaszuführung eine Schutzgaszufuhröffnung oberhalb des Ameisensäurespiegels aufweist. Mit dieser Ausführungsform des Ameisensäuredampferzeugers ist gewährleistet, dass die Schutzgaszuführung mit ihrer Schutzgaszufuhröffnung nicht in die Ameisensäure selbst eintaucht. Vielmehr wird das Schutzgas, das durch die Schutzgaszufuhröffnung einströmen kann, über den Ameisensäurenspiegel geleitet und sättigt sich mit Ameisensäuredampf, so dass ein ameisensäuredampfhaltiges Schutzgas unter Überdruck zwischen 0,5 und 1 MPa über die Druckgaszuführung dem Mehrzonenofen zugeführt werden kann. Dazu weist der Ameisensäuredampferzeuger in seinem oberen Bereich eine Auslassöffnung zu der Druckgaszuführung auf. Die Druckgaszuführung selbst ist mittig an dem Mehrzonenofen angeordnet, so dass sich die ameisensäuredampfhaltige Schutzgasatmosphäre sowohl zur Eingangs- als auch zur Ausgangspforte hin gleichmäßig im Ofenvolumen ausbreiten kann.

Neben den temperaturgeregelten Heizzonen kann der Mehrzonenofen auch im Bereich der Ausgangspforte eine Kühlzone aufweisen, die eine Abkühlrate von 5° pro Sekunde bis 10° pro Sekunde für die Abkühlung der elektronischen Bauteile gewährleistet. In einer weiteren Ausführungsform der Vorrichtung sind drei Heizzonen für die unterschiedlichen Haltetemperaturen und für die Endtemperatur vorgesehen. Dieses hat den Vorteil, dass der Mehrzonenofen relativ kurzfristig auf andere Materialzusammensetzungen der zu glättenden Schicht eingestellt werden kann.

Der Mehrzonenofen kann ein Transportband aufweisen, auf dem mehrere elektronische Bauteile für einen Durchlauf durch die Zonen hintereinander angeordnet sind. Ein derartiges Transportband ist aus Transportbandgliedern aufgebaut, die nicht mit der ameisensäuredampfhaltigen Schutzgasatmosphäre reagieren oder die elektronischen Bauteile nicht kontaminieren. Ein derartiges Transportband kann ein Endlosband darstellen, so dass ständig elektronische Bauteile hintereinander in dem Mehrzonenofen mit ihren Außenkontaktflächen fließtechnisch bearbeitet beziehungsweise formiert werden können.

Durch ein zentrales Steuerung-, Regelungs- und Überwachungsgerät kann die Transportgeschwindigkeit des Transportbandes, die Temperatur der einzelnen Zonen des Mehrzonenofen, die Heizung des Ameisensäuredampferzeugers, der Zuführungsdruck in der Druckgaszuführung und der Schutzgasdurchfluss gesteuert, geregelt und überwacht werden. Durch Programmieren des zentralen Steuerungsgerätes kann das Formieren oder fließtechnische Bearbeiten, das im Extremfall zu einem Umschmelzen der galvanisch aufgebrachten Schicht führt, vollkommen automatisch gesteuert werden, so dass die Verfahrensabläufe keines direkten Eingriffs bedürfen. Außerdem können in dem Steuerungsgerät unterschiedliche Ablaufprogramme, die den unterschiedlichen Materialien der galvanisch abgeschiedenen Schicht angepaßt sind, gespeichert werden und geeignet abgerufen werden.

Mit dieser Vorrichtung kann ein elektronisches Bauteil mit Außenkontaktflächen, die eine Schicht aus Metall oder einer Metall-Legierung aufweisen, wobei die Dicke der Schicht eines flächigen Außenkontakts von einem Zentrumsbereich zu einem Randbereich der Außenkontaktfläche abnimmt, hergestellt werden. Dazu wird zunächst ein Flachleiterrahmen für mehrere elektronische Bauteile mit Außenkontaktflächen bereitgestellt. Danach werden die elektronischen Bauteile auf dem Flachleiterrahmen vervollständigt, indem Halbleiterchips unter Verbinden des Halbleiterchips und seiner Kontaktflächen mit den Außenkontaktflächen des Flachleiterrahmens aufgebracht und in einer Kunststoffgehäusemasse auf dem Flachleiterrahmen verpackt werden. Anschließend wird für mehrere Bauteile im Flachleiterrahmen-Verbund gleichzeitig eine Schicht galvanisch auf dem Flachleiterrahmen unter Beschichten der Außenkontaktflächen (mit Metall oder einer Metall-Legierung) abgeschieden. Schließlich wird die Schicht auf den Außenkontaktflächen der elektronischen Bauteile im Flachleiterrahmen-Verbund unter Erwärmung des elektronischen Bauteils in einer ameisensäuredampfhaltigen Schutzgasatmosphäre bis mindestens zu der Fließtemperatur der Schichtoberfläche fließtechnisch bearbeitet. Durch Ausstanzen der Bauteile mit galvanisch beschichteten und fließtechnisch bearbeiteten Außenkontaktflächen aus dem Flachleiterrahmen werden die Bauteile des Flachleiterrahmens vereinzelt.

Damit steht ein elektronisches Bauteil zur Verfügung, das aufgrund der Wirkung der Ameisensäure nicht allein eine von Metalloxiden reduzierte Oberfläche aufweist, sondern aufgrund der thermischen Behandlung eine glänzende und glatte Oberfläche besitzt, vollständig oxidfrei ist und einen geringen Kontaktwiderstand aufweist. Darüber hinaus ist durch die fließtechnische Behandlung unter Ameisensäuredampf die Oberfläche gehärtet gegenüber der galvanisch abgeschiedenen Oberfläche, so dass eine Migration von Blei oder Zinn beim Testen der elektronischen Bauteile vermindert ist. Dieses verringert gleichzeitig die Kontaminationsgefahr für die Testköpfe, mit denen die Funktionstüchtigkeit der elektronischen Bauteile überprüft wird.

Die Metall-Legierungen der Schichten auf den Außenkontakten des elektronischen Bauteils können Legierungen aus Zinn/Blei oder Zinn/Blei/Silber oder Wismut/Silber/Kupfer oder Wismut/Nickel/Kupfer sein. Diese Legierungen haben die gemeinsame Eigenschaft, dass sie lötbar sind. Sie ermöglichen, dass die Außenkontaktflächen unmittelbar mit entsprechenden Kontaktflächen eines übergeordneten Schaltungssystems verbunden werden können. Die Zusammensetzung der Legierungen im einzelnen sind für Zinn, Blei und Silber bereits oben genannt, während die Metall-Legierung Wismut/Silber/Kupfer vorzugsweise 50 bis 80 Atom % Wismut, 5 bis 40 Atom % Silber und 0,5 bis 15 Atom % Kupfer aufweist. Diese Legierung hat den Vorteil, dass sie die hochtoxischen Schwermetalle Zinn und Blei nicht aufweist. Eine Legierung, die auf Wismut/Nickel/Kupfer basiert, weist vorzugsweise 50 bis 85 Atom % Wismut, 15 bis 45 Atom % Kupfer und 0,5 bis 5 Atom % Nickel auf.

Während die erste Haltetemperatur zur Trocknung der Beschichtung für alle Legierungsschichten bei Temperaturen zwischen 100 und 110° liegt, ist die zweite Haltetemperatur um wenige 10° unterhalb der Fließtemperatur der Oberfläche der jeweiligen Schicht angeordnet und variiert somit zwischen den einzelnen eingesetzten Legierungen. Das gleich gilt für die höchste Endtemperatur, die mindestens die Fließtemperatur der jeweiligen Legierung erreichen soll. Auch diese ist individuell von den eingesetzten Metall-Legierungen der Schicht abhängig. Demgegenüber kann jedoch die Erzeugung der ameisensäuredampfhaltigen Schutzgasatmosphäre für das elektronische Bauteil dem oben beschriebenen Verfahren entsprechen, wobei der Druck in der Druckgaszuführung in der gleichen Größenordnung zwischen 0,5 und 1 MPa liegt.

Die Verweilzeiten bei den unterschiedlichen Haltetemperaturen liegen, wie in dem oben beschriebenen Verfahren, zwischen 10 und 40 Sekunden, wobei die Aufheizzeit zwischen der ersten Haltetemperatur und der zweiten Haltetemperatur wiederum abhängig von der Fließtemperatur der jeweiligen Schichtlegierung ist. Die Abkühlrate nach Erreichen der Fließtemperatur kann in dem oben angegebenen Bereich zwischen 5 °C pro Sekunde und 10 °C pro Sekunde liegen und ist lediglich von der Temperaturwechselempfindlichkeit des elektronischen Bauteils abhängig und hat primär keine Abhängigkeit von der Zusammensetzung der Metall-Legierung für die auf die Außenkontaktflächen aufgebrachte Schicht.

Zusammenfassend kann festgestellt werden, dass sich durch Umschmelzen des galvanischen Platings von Außenkontaktflächen unter einer Atmosphäre vorzugsweise aus Stickstoff und Ameisensäuredämpfen eine glatte, gehärtete und nahezu oxidfreie Oberfläche mit günstigeren Eigenschaften bezüglich Kontaktverschmutzung, Migration und Übergangswiderstand ergibt. Da bei diesem Verfahren kein Flussmittel eingesetzt wird, ist auch keine nachträgliche Reinigung der Bauelemente erforderlich. Die erzeugten Formiate während der fließtechnischen Bearbeitung in einer ameisensäuredampfhaltigen Schutzgasatmosphäre durch die Absaugung des Ofens an Eingangs- und Ausgangspforte entfernt.

Ein Umschmelzen von galvanisch abgeschiedenen Schichten auf den Außenkontaktflächen kann für alle elektronischen Bauteile in der ameisensäuredampfhaltigen Schutzgasatmosphäre durchgeführt werden und hat sich für P-VQFN-Bauelemente bewährt. Um eine entsprechend hohe Konzentration der Ameisensäuredämpfe in der Schutzgasatmosphäre zu erhalten, wird der Druckbehälter des Ameisensäuredampferzeugers auf eine Temperatur zwischen 40 und 60°C aufgeheizt.

Eine fließtechnische Nachbearbeitung galvanisch abgeschiedener Schichten sollte unmittelbar nach der galvanischen Abscheidung erfolgen oder das Bauteil ist in einer stickstoffhaltigen Inertgasatmosphäre zwischenzulagern, zumal der Reduktionsvorgang bei dickeren Oxiden, die bei einer Zwischenlagerung an Luft entstehen, in dem Ameisensäuredampf nicht optimal und gleichmäßig verläuft. Über die Anwendung des Verfahrens zum fließtechnischen Bearbeiten von beschichteten Außenkontaktflächen kann auch das Anschmelzen von Kontaktbällen von BGA-Bauteilen (ball-grid-array-Bauteilen) nach dem Anbringen der Kontaktbälle auf den entsprechenden Außenkontaktflächen erfolgen. Dabei ergibt sich durch die oxidfreien Balls ein besser vergleichbares Testergebnis beim Funktionstest der elektronischen Bauteile.

Die Erfindung wird nun anhand von Ausführungsformen mit Bezug auf die beiliegenden Figuren näher erläutert.
- Figur 1: zeigt eine Prinzipskizze einer **erfindungsgemäßen** Vorrichtung zur Durchführung des Verfahrens,
- Figur 2: zeigt schematisch einen vergrößerten Querschnitt durch einen Außenkontakt mit einer galvanisch aufgebrachten Schicht,
- Figur 3: zeigt schematisch einen vergrößerten Querschnitt durch einen Außenkontakt mit einer galvanisch aufgebrachten Schicht nach einer fließtechnischen Bearbeitung der Schicht,
- Figur 4: zeigt eine Prinzipskizze eines Temperatur-Zeitdiagramms einer fließtechnischen Bearbeitung eines elektronischen Bauteils mit beschichteten Außenkontaktflächen,
- Figur 5: zeigt schematisch eine Seitenansicht eines P-VQFN-Bauteils mit fließtechnisch bearbeiteten Schichten auf Außenkontaktflächen,
- Figur 6: zeigt eine schematische Untersicht des P-VQFN-Bauteils der Figur 5.

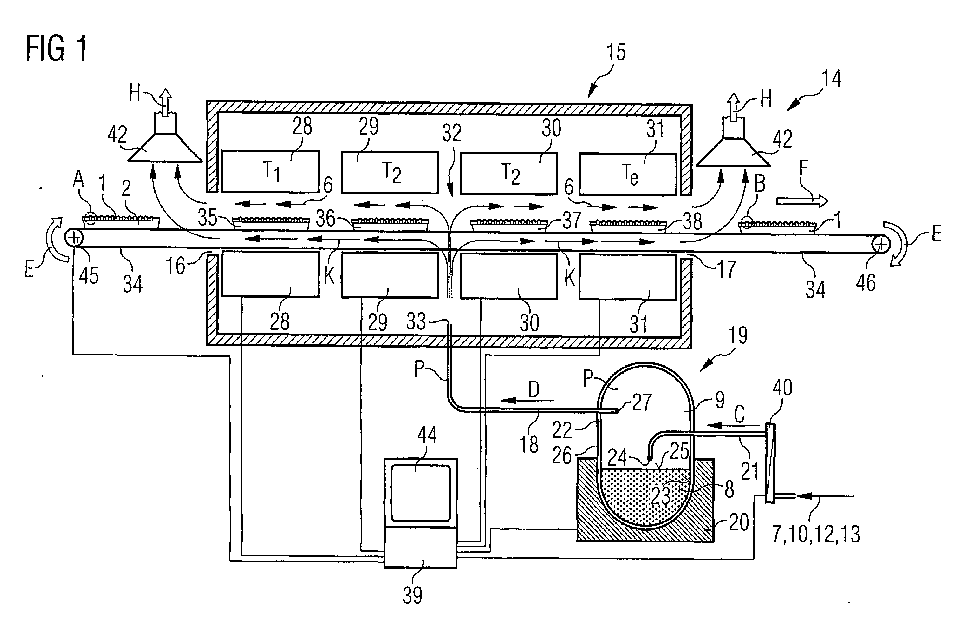

Figur 1 zeigt eine Prinzipskizze einer Vorrichtung 14 zur Durchführung des Verfahrens. Die Bezugszeichen 1, 35, 36, 37 und 38 kennzeichnen elektronische Bauteile, die auf einem Transportband 34 durch einen Mehrzonenofen 15 schrittweise durch die Heizzonen 28, 29, 30 und 31 des Mehrzonenofens 15 transportiert werden. Das Bezugszeichen 6 kennzeichnet eine ameisensäuredampfhaltige Schutzgasatmosphäre, die durch den Mehrzonenofen 15 in den Pfeilrichtungen K strömt und das gesamte innere Ofenvolumen 32 füllt. Das Bezugszeichen 7 kennzeichnet ein Schutzgas, das über einen Durchflussmesser 40 und eine Schutzgaszuführung 21 in Pfeilrichtung C in einen Druckbehälter 22 des Ameisensäuredampferzeugers 19 unter einem Druck P von 0,5 bis 1 MPa gepresst wird.

Das Bezugszeichen 8 kennzeichnet Ameisensäure, die in dem Ameisensäuredampferzeuger 19 im unteren Bereich 23 des Druckbehälters 22 angeordnet ist. Das Bezugszeichen 9 kennzeichnet Ameisensäuredampf, der oberhalb des Flüssigkeitsspiegels 25 der Ameisensäure 8 aufgrund einer Aufheizung der Ameisensäure 8 durch einen den unteren Bereich 23 des Druckbehälters 22 umgebenden Heizer 20 gebildet wird. Dieser Heizer 20 hält die Temperatur der Ameisensäure 8 auf 40°C bis 60°C. Durch das aus der Schutzgaszuführöffnung 24 ausströmende Schutzgas 7 wird der Ameisensäuredampf 9 über eine Druckgaszuführung 18 in Pfeilrichtung D etwa mittig in den Mehrzonenofen 15 eingeleitet.

Um eine intensive Mischung des Ameisensäuredampfes mit dem Schutzgas zu erreichen, ist die Schutzgaszufuhröffnung 24 über dem Ameisensäurespiegel 25 angeordnet. Die Auslassöffnung 27 für das ameisensäuredampfhaltige Schutzgas 7 ist im oberen Bereich 26 des Dampferzeugers 19 angeordnet. Als Schutzgas 7 können über den Flussmesser 40 Inertgase 10, Formiergase 12 oder Stickstoff 13 in den Ameisensäuredampferzeuger 19 über die Schutzgaszuführung 21 und die Schutzgaszufuhröffnung 24 geleitet werden. Während Inertgas und Stickstoff in keiner Weise mit der Ameisensäure und mit den elektronischen Bauteilen sowie der Schicht auf den Außenkontaktflächen der elektronischen Bauteile reagieren, unterstützt Formiergas durch seinen Wasserstoffanteil die Reduktion der schwach oxidierten Oberflächen der galvanisch abgeschiedenen Schichten auf den Außenkontaktflächen der elektronischen Bauteile 35, 36, 37 und 38, die sich in der ameisensäuredampfhaltigen Schutzgasatmosphäre des Mehrzonenofens befinden.

Beim Betrieb des Ofens 15 ist das innere Ofenvolumen 32 vollständig mit ameisensäuredampfhaltiger Schutzgasatmosphäre 6 aufgefüllt und aufgrund eines Überdrucks tritt die ameisensäuredampfhaltige Schutzgasatmosphäre sowohl an der Eingangspforte 16 als auch an der Ausgangspforte 17 des Mehrzonenofens 15 heraus und wird von Abzugshauben 42 aufgefangen und in Pfeilrichtung H einem Abgasreinigungssystem zugeführt. Zum zentrierten Einleiten der ämeisensäuredampfhaltigen Schutzgasatmosphäre 6 in den Mehrzonenofen 15 ist eine Öffnung 33 der Druckzuführung 18 zentral im Mehrzonenofen 15 zwischen den mittleren Heizzonen 29 und 30 angeordnet.

Das Bezugszeichen 39 kennzeichnet ein Steuerungs-, Regelungs- und Überwachungsgerät, das einen Monitor 44 zur Überwachung der Funktionsfähigkeit der Vorrichtung aufweist. Das Steuerungs-, Regelungs- und Überwachungsgerät 39 steht in Verbindung mit dem Durchflussmesser 40, um den Durchfluss des Schutzgases 7 zu regeln. Weitere Datenleitungen des Steuerungs-, Regelungs- und Überwachungsgerätes verbinden dieses mit der Heizung 20 des Ameisensäuredampferzeugers 19 zur Regelung und Konstanthaltung der Temperatur der Ameisensäure 8 und weitere Datenleitungen verbinden das Steuerungs-, Regelungs- und Überwachungsgerät 39 mit den Heizzonen 28, 29, 30 und 31 des Mehrzonenofens 15.

Über eine weitere Datenleitung, die mit dem Transportband 34 in Wirkverbindung steht, wird die Antriebsrolle 45 des Transportbandes 34 gesteuert, um gleichbleibende Verweilzeiten der elektronischen Bauteile 35, 36, 37 und 38 in den Zonen 28, 29, 30 und 31 des Mehrzonenofens 15 zu gewährleisten. Dazu wird die Antriebsrolle 45 in Pfeilrichtung E gedreht, so dass die elektronischen Bauteile in Pfeilrichtung F transportiert werden können. Die Umlenkungsrolle 46 auf der Ausgangspfortenseite lenkt unter mit gleicher Drehrichtung E wie die Antriebsrolle 45 das Endlostransportband 34 zurück zur Antriebsrolle 45 um.

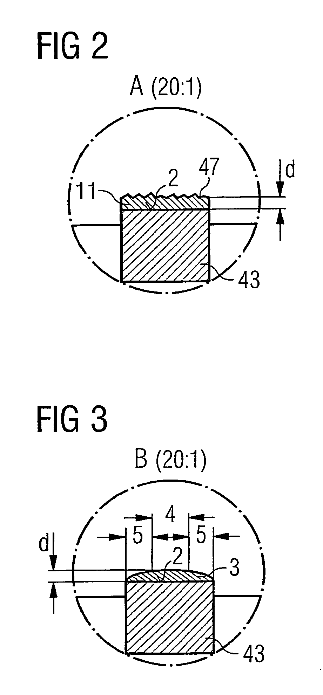

Figur 2 zeigt schematisch ein vergrößertes Detail A der Figur 1 mit einem vergrößerten Querschnitt durch einen Außenkontakt 43 einer galvanisch aufgebrachten Schicht 11. Derartige Außenkontakte 43 mit galvanisch abgeschiedenen Schichten von lötbarem Material weisen die Bauteile 1 auf, wenn sie über die Eingangspforte 16 auf dem Transportband 34 mit einem ersten Kontaktschritt in die Position der Heizzone 28 transportiert werden. Die in Figur 2 gezeigte, galvanisch abgeschiedene Schicht 11 auf der Außenkontaktfläche 2 des Außenkontaktes 43 zeigt eine matte Oberfläche, die entsprechend rau und uneben ist und relativ scharfe Kanten 47 aufweist, die bei der galvanischen Abscheidung entstehen.

Ein Bauteil mit derartigen Außenkontaktflächen kann einen Testkopf, der die Funktion der elektronischen Bauteile überprüfen soll, erheblich beschädigen, weil eine erhöhte Migration von Bestandteilen der lötbaren Legierung, wie Zinn/Blei/Silber oder Wismut/Silber/Kupfer oder Wismut/Nickel/Kupfer auftritt. Bei einem Zinn/Blei/Silber-Kontakt weist die Schicht 11 50 bis 70 Atom % Zinn, 30 bis 40 Atom % Blei und 1 bis 10 Atom % Silber auf. Bei einer Wismut/Silber/Kupfer-Schicht weist die Metall-Legierung 50 bis 80 Atom % Wismut, 5 bis 40 Atom % Silber und 0,5 bis 15 Atom % Kupfer auf. Bei einer Wismut/Nickel/Kupfer-Schicht weist die Schicht 50 bis 85 Atom % Wismut, 15 bis 45 Atom % Kupfer und 0,5 bis 5 Atom % Nickel auf.

Eine derartige Schicht 11, wie sie Figur 2 zeigt, wird mit dem Bauteil 1 über die Eingangspforte 16 wie in Figur 1 gezeigt auf dem Transportband 34 in die erste Heizzone 28 verbracht, in der das elektronische Bauteil auf eine erste Haltetemperatur T₁ von 100 bis 110°C aufgeheizt wird, um die Oberflächen von Feuchtigkeit zu befreien. Nach diesem Trocknen, das nach einer Verweilzeit von Δt beendet ist, wird das Transportband 34 schrittweise das elektronische Bauteil in die zweite Heizstation 29 verbringen, die auf eine zweiten Haltetemperatur T₂ aufgeheizt ist.

Die Haltetemperatur T₂ liegt wenige 10°C unterhalb der Fließtemperatur der Oberfläche der galvanischen Schicht 11. Nach einer Aufheizphase, die etwa auch das Zeitintervall Δt in Anspruch nimmt, wird das elektronische Bauteil in die dritte Heizzone 30 verfahren, die ebenfalls auf der Haltetemperatur T₂ liegt, so dass sich die Temperatur in dem gesamten elektronischen Bauteil stabilisieren kann. Erst danach wird das elektronische Bauteil in die vierte Position verbracht, die auf der höchsten Temperatur einer Endtemperatur Tₑ liegt, die mindestens der Fließtemperatur der galvanisch aufgebrachten Schicht 11 entspricht und nach einer gleichen Verweilzeit in dieser vierten Heizzone wird das Bauteil durch Herausfahren aus der Ausgangspforte 17 auf Raumtemperatur abgekühlt.

Figur 3 zeigt schematisch ein vergrößertes Detail B der Figur 1 mit einem vergrößerten Querschnitt durch einen Außenkontakt 43 einer galvanisch aufgebrachten Schicht nach einer fließtechnischen Bearbeitung der Schicht. Die fließtechnisch bearbeitete Schicht 3 auf dem Außenkontakt 43 weist eine glatte, glänzende Oberfläche auf, bei der alle Unebenheiten eingeebnet sind und hat in einem Zentrumsbereich 4 eine größere Dicke d als in den Randbereichen 5, in denen sie abgerundet ist und zu den Kanten hin abfällt. Neben der rein geometrischen Veränderung der fließtechnisch bearbeiteten Schicht 3 weist diese Schicht 3 auch eine höhere Oberflächenhärte auf als die Schicht 11, die in Figur 2 gezeigt wird. Darüber hinaus ist die fließtechnisch bearbeitete Schicht 3 durch die HCOOH-Moleküle des Ameisensäuredampfes reduziert, so dass eine reine Metalloberfläche auf den Außenkontakten 43 des elektronischen Bauteils zur Verfügung steht. Die Reduktion der Oberfläche der galvanisch abgeschiedenen Schicht 11 kann durch das Schutzgas unterstützt werden, indem anstelle eines Inertgases 10 ein Formiergas 12 eingeleitet wird, das neben Stickstoff 13 auch reduzierende Wasserstoffmoleküle enthält.

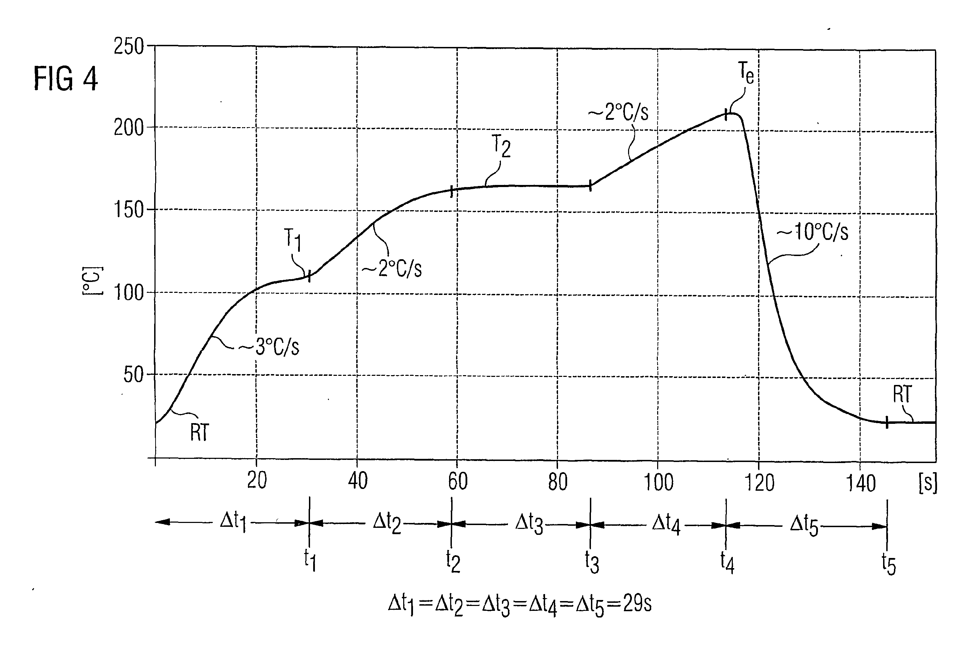

Figur 4 zeigt eine Prinzipskizze eines Temperatur-ZeitDiagramms einer fließtechnischen Bearbeitung eines elektronischen Bauteils mit galvanisch beschichteten Außenkontaktflächen. Die Figur 4 zeigt auf der Abszisse die Zeit t in Sekunden und auf der Ordinate die Temperatur T in °C. Die Raumtemperatur ist mit RT gekennzeichnet, außerdem sind zwei Haltetemperaturen T₁ bei 110° und T₂ bei 170° als Stufen in dem Temperatur-Zeit-Diagramm zu sehen. Nach der zweiten Haltetemperatur T₂ wird das elektronische Bauteil mit etwa 2°C pro Sekunde auf die höchste Endtemperatur Tₑ, die mindestens der Fließtemperatur der Materiallegierung der galvanisch abgeschiedenen Schicht entspricht, aufgeheizt. Unmittelbar nach Erreichen dieser höchsten Temperatur Tₑ kann das elektronische Bauteil entweder aktiv gekühlt werden mit bis zu 10°C/s oder aus einem Mehrzonenofen herausgefahren werden und auf Raumtemperatur RT abkühlen.

Die vier hier gezeigten Verweilzeiten Δt₁ bis Δt₄ sind gleich lang und entsprechen den vier Verweilzeiten, die in der Vorrichtung 14, wie sie Figur 1 zeigt, mit den viert Heizzonen 28, 29, 30 und 31 möglich sind. Die Verweilzeit Δt in diesem Ausführungsbeispiel beträgt 29 Sekunden, so dass schrittweise das elektronische Bauteil alle 29 Sekunden in die nächste Heizzone eingebracht werden kann. Während der ersten Verweilzeit Δt₁ in der ersten Heizzone des Mehrzonenofens der Figur 1 wird bei einem mittleren Temperaturanstieg von 3°C/s die Haltetemperatur T₁, die über dem Verdampfungspunkt von Wasser bei Normaldruck liegt, am elektronischen Bauteil erreicht. Danach wird das Bauteil in der zweiten Verweilzeit Δt₂ auf die zweite Haltetemperatur T₂ mit einem Temperaturanstieg von 2°C/s aufgeheizt.

Während einer dritten Verweilzeit Δt₃ wird das elektronische Bauteil in der dritten Heizzone auf der zweiten Haltetemperatur T₂ gehalten, und während der vierten Verweilzeit Δt₄ unter einem Temperaturanstieg von 2°C/s in der vierten Heizzone des Mehrzonenofens auf die höchste Endtemperatur Tₑ erhitzt, die mindestens der Fließtemperatur der Oberfläche der galvanischen Schicht entspricht. Für dieses Durchführungsbeispiel des Verfahrens zeigt das Diagramm das Abkühlen des elektronischen Bauteils auf Raumtemperatur RT nach dem Herausfahren des elektronischen Bauteils aus dem Mehrzonenofen 15, wie er in Figur 1 gezeigt wird. Dabei hat sich die Morphologie der galvanisch abgeschiedenen Schicht auf den Außenkontaktflächen, wie es der Vergleich der Figuren 2 und 3 zeigt, geändert.

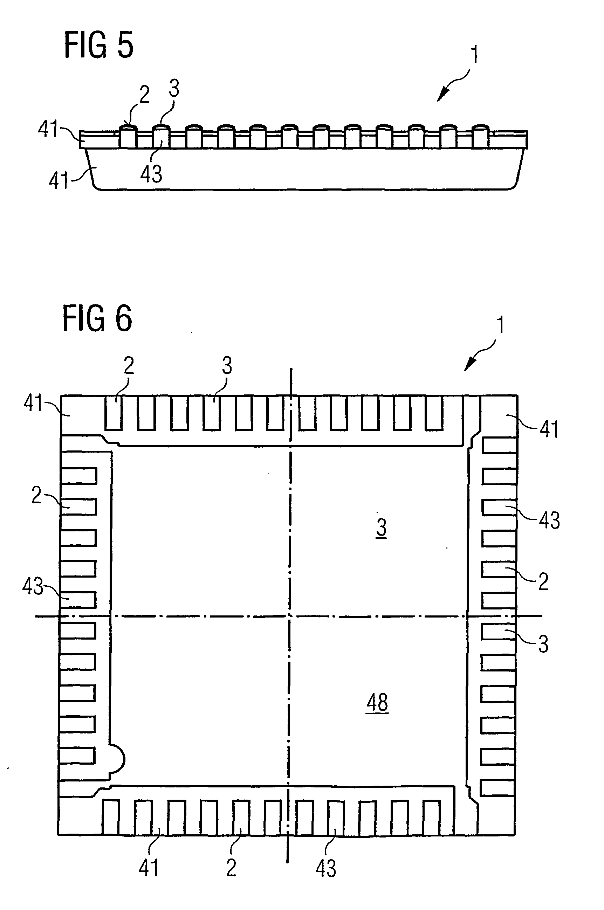

Figur 5 zeigt schematisch eine Seitenansicht eines P-VQFN-Bauteils mit fließtechnisch bearbeiteten Schichten 3 auf Außenkontaktflächen 2. Dabei sind die Außenkontakte 43 in eine Kunststoffgehäusemasse 41 eingebettet und werden von dieser in Position gehalten. Jeder der zwölf Außenkontakte 43 in dieser Seitenansicht weist eine geglättete, glänzende, lötbare Schicht 3 auf, die gegenüber der ursprünglich galvanisch abgeschiedenen Schicht in diesem Bereich eine größere Härte aufweist und somit eine Migration von Material von diesen Lötschichten beim Testen des elektronischen Bauteils 1 vermindert.

Figur 6 zeigt schematisch eine Untersicht auf das P-VQFN-Bauteil der Figur 5, wobei ein großflächiger Außenkontakt 48 das innere Zentrum der Unterseite des elektronischen Bauteils abdeckt. Auf diesem großflächigen Außenkontakt liegt die fließtechnisch bearbeitete Schicht 3 und bedeckt die gesamte Fläche des großflächigen Außenkontakts 48, der als Chipinsel dient und den von der hier gezeigten Untersicht nicht sichtbaren Halbleiterchip trägt. Insgesamt sind 48 Kontaktflächen 2 im Randbereich der Kunststoffgehäusemasse 41 angeordnet, von denen vier mit dem großflächigen Außenkontakt 48 der Chipinsel elektrisch verbunden sind. Sowohl der großflächige Außenkontakt 48 als auch die Außenkontakte 43 im Randbereich des elektronischen Bauteils sind in die Kunststoffgehäusemasse 41 eingebettet und sind einerseits von der hier gezeigten Unteransicht aus freigelegt und zusätzlich an den in Figur 5 gezeigten Seitenbereichen zugänglich.

## Patentansprüche

1. Vorrichtung für die Herstellung eines elektronischen Bauteils (1) mit Außenkontaktflächen (2), die eine Schicht aus Metall oder aus einer Metall-Legierung aufweisen, wobei die Vorrichtung (14) einen Mehrzonenofen (15) mit mehreren heizbaren Zonen sowie mit Eingangs- (16) und Ausgangspforte (17) und einer Druckgaszuführung sowie einen Ameisensäuredampferzeuger (19) mit Heizung (20) und einer Schutzgaszuführung (21) aufweist, wobei die Druckgaszuführung (18) mit dem Ameisensäuredampferzeuger (19) verbunden ist, die Druckgaszuführung mittig an dem Mehrzonenofen angeordnet ist, und die Heizungen des Mehrzonenofens so steuerbar sind, dass die Oberfläche der Schicht Fließtemperatur erreicht, **wobei in unterschiedlichen Heizzonen eine erste Haltetemperatur, eine zweite Haltetemperatur und eine Endtemperatur im Bereich der Fließtemperatur der Oberfläche der zu glättenden Schicht getrennt einstellbar und regelbar sind.**

2. Vorrichtung nach Anspruch 1,
**dadurch gekennzeichnet, dass**
der Ameisensäuredampferzeuger (19) einen Druckbehälter (22) aufweist, der in seinem unteren Bereich (23) mit Ameisensäure (8) gefüllt ist und von einer Heizung (20) umgeben ist, und wobei die Schutzgaszuführung (21) eine Schutzgaszufuhröffnung oberhalb des Ameisensäurespiegels (25) aufweist.

3. Vorrichtung nach Anspruch 1 der Anspruch 2,
**dadurch gekennzeichnet, dass**
der Mehrzonenofen (15) nach der Eingangspforte (16) drei Heizzonen (28, 29, 30) und im Bereich der Ausgangspforte (17) eine Kühlzone (31) aufweist und wobei sowohl die Eingangspforte (16) als auch die Ausgangspforte (17) über das Ofenvolumen (32).und die mittig angeordnete Öffnung (33) der Druckzuführung (18) mit ameisensäuredampfhaltigem Schutzgas (6) versorgt sind.

4. Vorrichtung nach einem der Ansprüche 1 bis 3,
**dadurch gekennzeichnet, dass**
der Mehrzonenofen (15) ein Transportband (34) aufweist, auf dem mehrere elektronische Bauteile (35, 36, 37, 38) für einen Durchlauf durch den Mehrzonenofen (15) hintereinander angeordnet sind.

5. Verwendung einer Vorrichtung nach einem der Ansprüche 1 bis 4 in einem Verfahren für die Herstellung eines elektronischen Bauteils (1) mit Außenkontaktflächen (2), die eine Schicht (3) aus Metall oder aus einer Metall-Legierung aufweisen, wobei die Dicke (d) der Schicht (3) eines Außenkontaktes (2) von einem Zentrumsbereich (4) zu einem Randbereich (5) abnimmt, und wobei das Verfahren folgende Verfahrensschritte aufweist:
- Herstellen eines elektronischen Bauteils (1) mit Außenkontaktflächen (2), die eine galvanisch abgeschiedene, matte, unebene und scharfkantige Schicht (11) aus Metall oder Metall-Legierungen auf den Außenkontaktflächen (2) aufweisen,
- fließtechnisches Bearbeiten der Schicht (11) auf den Außenkontakten (2) des elektronischen Bauteils (1) unter Erwärmen des elektronischen Bauteils (1) in einer reduzierenden Atmosphäre (6) bis zu einer Fließtemperatur der Schichtoberfläche.

## Claims

1. An apparatus for the production of an electronic component (1) with external contact areas (2), which have a layer of metal or of a metal alloy, the apparatus (14) having a multiple-zone furnace (15) with multiple heatable zones and an inlet port (16) and an outlet port (17), and a compressed gas feed and also a formic acid vapor generator (19) with heating means (20) and a protective gas feed (21), the compressed gas feed (18) being connected to the formic acid vapor generator (19) and the compressed gas feed being arranged centrally on the multiple-zone furnace, the heating means of the multiple-zone furnace being controllable so that the surface of the layer reaches flow temperature, wherein in different heating zones a first holding temperature, a second holding temperature and an end temperature in the range of the flow temperature of the surface of the layer to be smoothed are setable and regulateable separately.

2. The apparatus according to claim 1, **characterized in that** the formic acid vapor generator (19) has a pressure vessel (22), which is filled in its lower region (23) with formic acid (8) and is surrounded by a heating means (20), and the protective gas feed (21) having a protective gas feed opening above the level of the formic acid (25).

3. The apparatus according to claim 1 or claim 2, **characterized in that** the multiple-zone furnace (15) has three heating zones (28, 29, 30) after the inlet port (16) and a cooling zone (31) in the region of the outlet port (17), and both the inlet port (16) and the outlet port (17) being supplied with protective gas (6) containing formic acid vapor via the volume of the furnace (32) and the centrally arranged opening (33) of the pressure feed (18).

4. The apparatus according to one of claims 1 to 3, **characterized in that** the multiple-zone furnace (15) has a conveyor belt (34), on which a number of electronic components (35, 36, 37, 38) are arranged for passing the number of electronic components (35, 36, 37, 38) through the multiple-zone furnace (15) one after the other.

5. Use of an apparatus according to one of claims 1 to 4 in a method for the production of an electronic component (1) with external contact areas (2), which have a layer (3) of metal or of a metal alloy, the thickness (d) of the layer (3) of an external contact (2) decreasing from a central region (4) to a border region (5), and the method having the following method steps:
- producing an electronic component (1) with external contact areas (2), which have an electrodeposited, matt, uneven and sharp-edged layer (11) of metal or metal alloys on the external contact areas (2),
- fluidically processing the layer (11) on the external contacts (2) of the electronic component (1), with heating of the electronic component (1) in a reducing atmosphere (6) up to a flow temperature of the surface of the layer.

## Revendications

1. Dispositif de fabrication d'un composant électronique (1) qui présente des surfaces extérieures de contact (2) dotées d'une couche de métal ou d'alliage métallique,
le dispositif (14) présentant un four multizone (15) doté de plusieurs zones aptes à être chauffées et d'une porte d'entrée (16), d'une porte de sortie (17) et d'une amenée de gaz sous pression et un générateur (19) de vapeur d'acide formique doté d'un chauffage (20) et d'une amenée (21) de gaz protecteur,
l'amenée (18) de gaz sous pression étant reliée au générateur (19) de vapeur d'acide formique,
l'amenée de gaz sous pression étant disposée au milieu du four multizone et les chauffages du four multizone pouvant être commandés de telle sorte que la surface de la couche atteigne la température de liquéfaction,
une première température de maintien, une deuxième température de maintien et une température finale de l'ordre de la température de liquéfaction de la surface de la couche à lisser pouvant être établies et régulées séparément dans des différentes zones de chauffage.

2. Dispositif selon la revendication 1, **caractérisé en ce que** le générateur (19) de vapeur d'acide formique présente un récipient sous pression (22) dont la partie inférieure (23) est remplie d'acide formique (8) et qui est entouré par un chauffage (20), une ouverture d'amenée de gaz protecteur de l'amenée (21) de gaz protecteur étant située au-dessus du niveau (25) d'acide formique.

3. Dispositif selon la revendication 1 ou la revendication 2, **caractérisé en ce que** le four multizone (15) présente trois zones de chauffage (28, 29, 30) en aval de la porte d'entrée (16) et une zone de refroidissement (31) du côté de la porte de sortie (17), tant la porte d'entrée (16) que la porte de sortie (17) étant alimentées en gaz protecteur (6) contenant de la vapeur d'acide formique par l'intermédiaire du volume (32) du four et par l'ouverture (33) de l'amenée sous pression (18) disposée au milieu.

4. Dispositif selon l'une des revendications 1 à 3, **caractérisé en ce que** le four multizone (15) présente une bande de transport (34) sur laquelle plusieurs composants électroniques (35, 36, 37, 38) sont disposés les uns derrière les autres pour les faire traverser le four multizone (15).

5. Utilisation d'un dispositif selon l'une des revendications 1 à 4 dans un procédé de fabrication d'un composant électronique (1) qui présente des surfaces extérieures de contact (2) dotées d'une couche (3) de métal ou d'alliage métallique, l'épaisseur (d) de la couche (3) d'un contact extérieur (2) diminuant depuis une partie centrale (4) jusqu'à une bordure (5), le procédé présentant les étapes suivantes :
- fabrication d'un composant électronique (1) qui présente des surfaces extérieures de contact (2) dotées d'une couche (11) de métal ou d'alliage de métal, mate, non plane et à bord tranchant, déposée par galvanisation sur les surfaces extérieures de contact (2),
- traitement de liquéfaction de la couche (11) située sur les contacts extérieurs (2) du composant électronique (1) par chauffage du composant électronique (1) dans une atmosphère réductrice (6) jusqu'à une température de liquéfaction de la surface de la couche.
